# FASCICULE DE BREVET EUROPEEN

(11) **EP 3 389 091 B1**
(45) Date de publication et mention de la délivrance du brevet: **04.11.2020**
(21) Numéro de dépôt: 18165960.8
(22) Date de dépôt: 05.04.2018
(51) Int. Cl.: H01L 25/075, H01L 33/00, H01L 25/16, H01L 33/44, H01L 33/62

(54) **PROCÉDÉ DE FABRICATION D'UN DISPOSITIF D'AFFICHAGE ÉMISSIF À LED ET DISPOSITIF D'AFFICHAGE CORRESPONDANT**
HERSTELLUNGSVERFAHREN EINER LED-EMISSIONSANZEIGEVORRICHTUNG UND ENTSPRECHENDE LED-EMISSIONSANZEIGEVORRICHTUNG
METHOD FOR MANUFACTURING AN LED EMISSIVE DISPLAY AND CORRESPONDING LED EMISSIVE DISPLAY

(30) Priorité: 14.04.2017 FR 1753279
(43) Date de publication de la demande: 17.10.2018
(73) Titulaire: Commissariat à l'Energie Atomique et aux Energies Alternatives, 75015 Paris (FR)
(72) Inventeur: ROBIN, Ivan-Christophe, 38000 GRENOBLE (FR); BERTHIER, Jean, 38240 MEYLAN (FR); CHERAMY, Séverine, 38640 CLAIX (FR); DI CIOCCIO, Léa, 38330 SAINT ISMIER (FR)
(74) Mandataire: Cabinet Beaumont

(56) Documents cités:
- JP-A- 2005 174 979
- US-A1- 2007 126 016
- US-A1- 2011 033 976
- US-A1- 2012 223 875
- US-A1- 2014 191 246
- US-A1- 2015 228 631

## Description

### Domaine

La présente demande concerne la réalisation d'un dispositif d'affichage d'images émissif à diodes électroluminescentes (LED), par exemple un écran de télévision, d'ordinateur, de smartphone, de tablette numérique, etc.

### Exposé de l'art antérieur

Il a déjà été proposé, dans la demande de brevet français FR 3 044 467 A1 (n° d'enregistrement 1561421) déposée le 26 novembre 2015, un procédé de fabrication d'un dispositif d'affichage d'images comportant une pluralité de micropuces électroniques élémentaires disposées en matrice sur un même substrat de report. Selon ce procédé, les micropuces et le substrat de report sont fabriqués séparément. Chaque micropuce comprend un empilement d'une LED et d'un circuit de commande de la LED. Le circuit de commande comprend une face de connexion opposée à la LED, comprenant une pluralité de plages de connexion électrique destinées à être connectées au substrat de report pour la commande de la micropuce. Le substrat de report comprend une face de connexion comportant, pour chaque micropuce, une pluralité de plages de connexion électrique destinées à être connectées respectivement aux plages de connexion électrique de la micropuce. Les puces sont ensuite rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Il serait souhaitable de pouvoir améliorer au moins en partie certains aspects de ce procédé.

En particulier, du fait des dimensions relativement petites des micropuces, et étant donné que chaque micropuce comprend plusieurs plages de connexion électrique distinctes, l'alignement des plages de connexion électrique des micropuces sur les plages de connexion électrique correspondantes du substrat de report est relativement délicat à réaliser. Il serait souhaitable de pouvoir faciliter la mise en oeuvre de cet alignement et/ou améliorer la précision d'alignement obtenue.

Le document JP 2005 174979 A divulgue un procédé d'agencement de LED pour un dispositif d'affichage émissif à LED, le procédé consistant à agencer chaque LED à une position prédéterminée par auto-ajustement.

### Résumé

La présente invention prévoit un procédé de fabrication d'un dispositif d'affichage émissif à LED, comprenant les étapes suivantes :
a) réaliser une pluralité de puces comprenant chacune au moins une LED, et, sur une face de connexion de la puce, une pluralité de plages de connexion électrique hydrophiles et une zone hydrophobe, chaque plage de connexion électrique de la puce étant entourée et séparée des autres plages de connexion électrique de la puce par la zone hydrophobe ;
b) réaliser un substrat de report comprenant, pour chaque puce, sur une face de connexion du substrat de report, une pluralité de plages de connexion électrique hydrophiles destinées à être connectées respectivement aux plages de connexion électrique de la puce, et une zone hydrophobe, chaque plage de connexion électrique de substrat de report étant entourée et séparée des autres plages de connexion électrique du substrat de report par la zone hydrophobe ;
c) disposer une goutte d'un liquide sur chaque plage de connexion électrique du substrat de report et/ou sur chaque plage de connexion électrique de chaque puce ; et
d) fixer les puces sur le substrat de report par collage direct de façon à connecter électriquement les plages de connexion électrique de chaque puce aux plages de connexion électrique correspondantes du substrat de report, en utilisant la force de rappel de capillarité des gouttes pour aligner les plages de connexion électrique des puces sur les plages de connexion électrique correspondantes du substrat de report.

Selon un mode de réalisation, les plages de connexion électrique des puces et du substrat de report sont en métal, et les zones hydrophobes des puces et du substrat de report sont en un polymère hydrophobe.

Selon un mode de réalisation, les plages de connexion électrique des puces sont en un matériau formant un angle de goutte inférieur à 10° avec le liquide, et les zones hydrophobes sont en un matériau formant un angle de goutte supérieur à 20° avec le liquide.

Selon un mode de réalisation :
dans chaque puce, la face de connexion de la puce est plane, c'est-à-dire que les plages de connexion électrique de la puce affleurent au niveau de la face externe de la zone hydrophobe ; et/ou
la face de connexion du substrat de report est plane, c'est-à-dire que les plages de connexion électrique du substrat de report affleurent au niveau de la face externe de la zone hydrophobe.

Selon un mode de réalisation :
dans chaque puce, les plages de connexion électrique de la puce forment des protubérances en saillie de la face de connexion de la puce ; et/ou
les plages de connexion électrique du substrat de report forment des protubérances en saillie de la face de connexion du substrat de report.

Selon un mode de réalisation :
à l'issue de l'étape a), les puces sont disposées sur un substrat de support avec un pas inter-puces inférieur au pas inter-puces du dispositif d'affichage final ; et
à l'étape d), plusieurs puces sont sélectivement détachées du substrat de support au pas du dispositif d'affichage final et fixées au substrat de report à ce même pas.

Selon un mode de réalisation, le détachement sélectif des puces est réalisé au moyen d'un faisceau laser localisé projeté depuis la face du substrat de support opposée aux puces.

Selon un mode de réalisation, le substrat de support présente une ou plusieurs ouvertures traversantes en regard de chaque puce, le détachement sélectif des puces étant réalisé par l'intermédiaire de ces ouvertures.

Selon un mode de réalisation :
à l'issue de l'étape a), les puces sont seulement posées, sans collage, sur le substrat de support ; et
à l'étape d) le substrat de report est amené au-dessus des puces, face de connexion tournée vers les faces de connexion des puces, et posé sur les puces de façon à prélever simultanément plusieurs puces au pas du dispositif d'affichage final.

Selon un mode de réalisation, le substrat de support comprend des cavités dans lesquelles sont disposées les puces de façon que les puces soient maintenues latéralement par les parois des cavités.

Selon un mode de réalisation, le fond de chaque cavité du substrat de support est non plan.

Selon un mode de réalisation, chaque puce comprend un empilement d'une LED et d'un circuit actif de commande de la LED.

La présente invention prévoit également un dispositif d'affichage émissif à LED réalisé par un procédé tel que défini ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe illustrant de façon schématique et partielle une étape de report d'une micropuce sur un substrat de report, selon un exemple d'un procédé de fabrication d'un dispositif d'affichage émissif à LED ;
la figure 2 est une vue en coupe illustrant de façon schématique et partielle une étape de report d'une micropuce sur un substrat de report, selon un exemple d'un mode de réalisation d'un procédé de fabrication d'un dispositif d'affichage émissif à LED ;
la figure 3 est une vue en coupe illustrant de façon schématique et partielle une étape de report d'une micropuce sur un substrat de report, selon un autre exemple d'un mode de réalisation d'un procédé de fabrication d'un dispositif d'affichage émissif à LED ;
les figures 4A, 4B et 4C sont des vues en coupe illustrant des étapes d'un exemple d'un mode de réalisation d'un procédé de fabrication d'un dispositif d'affichage émissif à LED ;
la figure 5 est une vue en coupe illustrant une variante de réalisation du procédé des figures 4A à 4C ;
les figures 6A, 6B, 6C et 6D sont des vues en coupe illustrant des étapes d'un autre exemple d'un mode de réalisation d'un procédé de fabrication d'un dispositif d'affichage émissif à LED ;
les figures 7A, 7B, 7C et 7D sont des vues en coupe illustrant des étapes d'un autre exemple d'un mode de réalisation d'un procédé de fabrication d'un dispositif d'affichage émissif à LED ; et
la figure 8 est une vue en coupe illustrant une variante de réalisation du procédé des figures 7A à 7D.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la fabrication des micropuces élémentaires et du substrat de report des dispositifs d'affichage décrits n'a pas été détaillée, la fabrication de ces éléments étant à la portée de l'homme du métier à partir des enseignements de la présente description. A titre d'exemple, les micropuces élémentaires et le substrat de report peuvent être fabriqués selon des procédés identiques ou similaires à ceux décrits dans la demande de brevet français FR 3 044 467 A1 susmentionnée. Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des figures, étant entendu que, dans la pratique, les dispositifs décrits peuvent être orientés différemment. Sauf précision contraire, les expressions "approximativement", "sensiblement", et "de l'ordre de" signifient à 10 % près, de préférence à 5 % près.

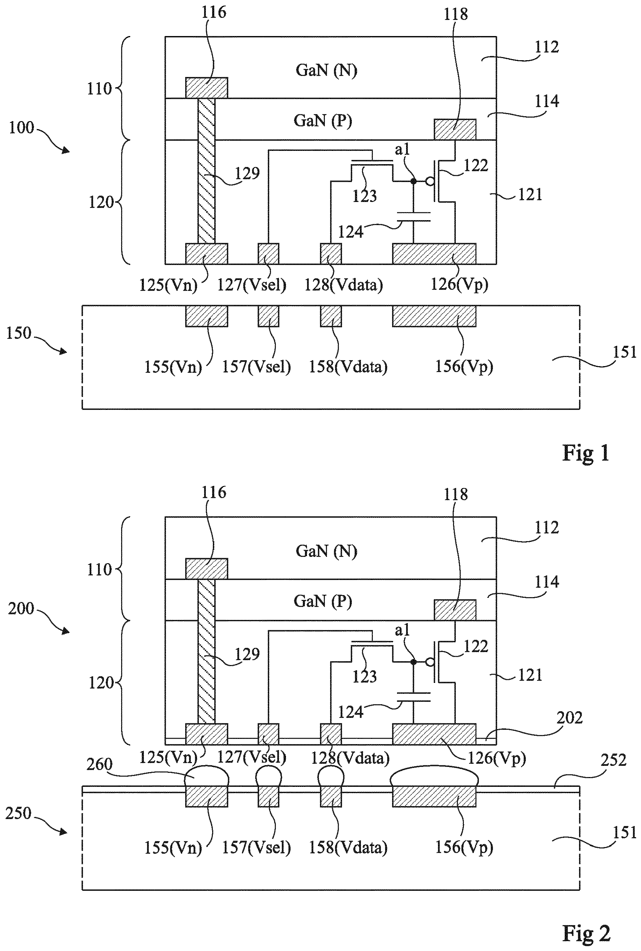

La figure 1 est une vue en coupe illustrant de façon schématique et partielle une étape de report d'une micropuce 100 sur un substrat de report 150, selon un exemple d'un procédé de fabrication d'un dispositif d'affichage émissif à LED.

La figure 1 représente plus particulièrement la micropuce 100 et le substrat de report 150 avant l'étape proprement dite de fixation de la micropuce sur le substrat de report.

En pratique, un dispositif d'affichage peut comporter une pluralité de puces élémentaires 100 identiques ou similaires montées sur un même substrat de report selon un agencement en matrice selon des lignes et des colonnes, les puces étant connectées à des éléments de connexion électrique du substrat pour leur commande, et chaque micropuce correspondant par exemple à un pixel du dispositif d'affichage.

La micropuce 100 comprend, dans une portion supérieure, une LED semiconductrice inorganique 110, et, dans une portion inférieure solidaire de la portion supérieure, un circuit de commande actif 120 à base de silicium monocristallin, adapté à contrôler l'émission de lumière par la LED.

La LED 110 comprend au moins une homojonction ou une hétérojonction, par exemple une jonction PN formée d'un empilement d'une couche semiconductrice supérieure de type N 112 et d'une couche semiconductrice inférieure de type P 114, et deux contacts électriques 116 et 118 (respectivement en contact avec la couche 112 et avec la couche 114 dans l'exemple représenté) pour injecter un courant électrique au travers de l'empilement, afin de produire de la lumière. A titre d'exemple, la LED 110 est une LED au nitrure de gallium ou à base de tout autre semiconducteur III-V adapté à la réalisation d'une LED.

Le circuit de commande 120 est réalisé dans et sur un bloc de silicium monocristallin 121, et comprend des composants électroniques, et notamment un ou plusieurs transistors et au moins un élément capacitif de maintien d'un signal de polarisation, pour la commande individuelle de la LED 110. La face supérieure du circuit de commande 120 est en contact mécaniquement et électriquement avec la LED 110. La face inférieure du circuit 120, définissant une face de connexion de la micropuce, comprend une pluralité de plages de connexion électrique destinées à être connectées à des plages de connexion électrique correspondantes du substrat de report 150 pour la commande de la micropuce. Dans l'exemple représenté, la face inférieure du circuit 120 comprend quatre plages de connexion électrique 125, 126, 127 et 128. Les plages 125 et 126 sont destinées à recevoir respectivement un potentiel d'alimentation bas (par exemple la masse) Vn et un potentiel d'alimentation haut (c'est-à-dire supérieur au potentiel d'alimentation bas) Vp de la micropuce. Les plages 127 et 128 sont destinées à recevoir des signaux de commande de la micropuce. Plus particulièrement, la plage 127 est destinée à recevoir un signal Vsel de sélection de la micropuce, et la plage 128 est destinée à recevoir un signal Vdata de réglage du niveau de luminosité de la micropuce. Les plages de connexion 125, 126, 127 et 128 sont par exemple en métal, par exemple en cuivre. Dans cet exemple, le circuit de commande 120 comprend deux transistors MOS 122 et 123 et un élément capacitif 124, par exemple un condensateur. Le transistor 122, par exemple un transistor à canal P, a un premier noeud de conduction (source ou drain) connecté à la plage de connexion 126 (Vp) de la micropuce, un deuxième noeud de conduction (drain ou source) connecté à la borne de contact d'anode 118 de la LED 110, et un noeud de commande (grille) connecté à un noeud intermédiaire a1 du circuit 120. L'élément capacitif 124 a une première électrode connectée au noeud a1 et une deuxième électrode connectée à la plage de connexion 126 (Vp) de la micropuce. Le transistor 123, par exemple un transistor à canal N a un premier noeud de conduction connecté à la plage de connexion 128 (Vdata) de la micropuce, un deuxième noeud de conduction connecté au noeud a1, et un noeud de commande connecté à la plage de connexion 127 (Vsel) de la micropuce. La micropuce 100 comprend en outre un via conducteur isolé 129 connectant la plage de connexion électrique 125 (Vn) de la micropuce à la borne de contact de cathode 116 de la LED 110.

Le fonctionnement de la micropuce élémentaire 100 lors d'une phase de mise à jour du niveau de luminosité du pixel est le suivant. Le transistor 123 est fermé (rendu passant) par l'application d'un signal de commande adapté sur la borne 127 (Vsel). L'élément capacitif 124 se charge alors à un niveau de tension fonction du signal de réglage appliqué sur la borne 126 (Vdata) de la micropuce. Le niveau du signal de réglage Vdata fixe le potentiel du noeud a1, et par conséquent l'intensité du courant injecté dans la LED par le transistor 122, et donc l'intensité lumineuse émise par la LED. Le transistor 123 peut ensuite être rouvert. Le noeud a1 reste alors à un potentiel sensiblement égal au potentiel Vdata. Ainsi, le courant injecté dans la LED reste sensiblement constant après la réouverture du transistor 123, et ce jusqu'à la prochaine mise à jour du potentiel du noeud a1.

Le substrat de report 150 comprend par exemple une plaque ou une feuille de support 151 en un matériau isolant, sur laquelle sont disposés des éléments de connexion électrique, par exemple des pistes et plages conductrices. Le substrat de report 150 est par exemple un substrat passif, c'est-à-dire qu'il comprend uniquement des éléments de connexion électrique pour l'amenée des signaux de commande et d'alimentation des micropuces. Le substrat de report 150 comprend une face de connexion, sa face supérieure dans l'exemple représenté, destinée à recevoir les micropuces 100. Pour chaque micropuce du dispositif d'affichage, le substrat de report 150 comprend, sur sa face de connexion, une pluralité de plages de connexion électrique (une par plage de connexion électrique de la micropuce) destinées à être connectées respectivement aux plages de connexion électrique de la micropuce. Ainsi, dans cet exemple, pour chaque micropuce 100 du dispositif d'affichage, le substrat de report 150 comprend quatre plages de connexion électrique 155, 156, 157 et 158 destinées à être connectées respectivement aux plages de connexion électrique 125, 126, 127 et 128 de la micropuce 100, pour l'amenée des signaux de commande Vn, Vp, Vsel et Vdata de la micropuce. Les plages de connexion électrique 155, 156, 157 et 158 du substrat de report sont par exemple en le même matériau conducteur que les plages de connexion électrique 125, 126, 127 et 128 des micropuces, par exemple du cuivre.

Lors du report de la micropuce 100 sur le substrat de report 150, la face de connexion de la micropuce est mise en contact avec la face de connexion du substrat de report de façon à connecter électriquement les plages de connexion électrique 125, 126, 127 et 128 de la micropuce respectivement aux plages de connexion électrique correspondantes 155, 156, 157 et 158 du substrat de report. La fixation de la micropuce 100 sur le substrat de report est réalisée par collage direct, c'est-à-dire sans apport de matière adhésive ou de brasure à l'interface entre la micropuce et le substrat, par exemple à température et à pression ambiante. Pour cela, les plages de connexion électrique de la micropuce et du substrat de report peuvent avoir été préparées au préalable pour obtenir une planéité suffisante, par exemple une rugosité inférieure à 1 nm, pour réaliser un collage direct des plages 125, respectivement 126, respectivement 127, respectivement 128, sur les plages 155, respectivement 156, respectivement 157, respectivement 158. Un recuit peut éventuellement être prévu après le collage, par exemple à une température comprise entre 150 et 250°C, pour augmenter la force du collage.

Comme indiqué ci-dessus, une difficulté d'un tel procédé réside dans l'alignement des plages de connexion électrique de la micropuce sur les plages de connexion électrique correspondantes du substrat de report en vue d'obtenir une bonne connexion électrique entre la micropuce et le substrat de report.

En effet, les micropuces ont par exemple, en vue de dessus, une dimension maximale inférieure ou égale à 100 µm, par exemple inférieure ou égale à 50 µm, par exemple de l'ordre de 10 µm. Chaque micropuce comportant plusieurs plages de connexion électrique (quatre dans l'exemple de la figure 1), l'alignement des micropuces doit être très précis, par exemple précis à mieux que 1 µm.

La figure 2 est une vue en coupe illustrant de façon schématique et partielle une étape de report d'une micropuce 200 sur un substrat de report 250, selon un exemple d'un mode de réalisation d'un procédé de fabrication d'un dispositif d'affichage émissif à LED. La figure 2 représente plus particulièrement la micropuce 200 et le substrat de report 250 avant l'étape proprement dite de fixation de la micropuce sur le substrat de report.

La micropuce 200 et le substrat de report 250 de la figure 2 comprennent des éléments communs avec la micropuce 100 et le substrat de report 150 de la figure 1. Dans la suite, seules les différences entre le mode de réalisation de la figure 2 et l'exemple de la figure 1 seront détaillées.

La micropuce 200 de la figure 2 diffère de la micropuce 100 de la figure 1 principalement en ce qu'elle comprend, du côté de sa face de connexion, une couche hydrophobe 202 en un matériau électriquement isolant, entourant latéralement les plages de connexion électrique 125, 126, 127 et 128 de la micropuce. Dans l'exemple représenté, la couche hydrophobe 202 s'étend sur sensiblement toute la surface inférieure de la micropuce non occupée par les plages de connexion électrique 125, 126, 127 et 128. A titre d'exemple, en vue de face, chacune des plages de connexion électrique 125, 126, 127 et 128 de la micropuce est entièrement entourée par la couche hydrophobe 202 et séparée des autres plages de connexion électrique par la couche hydrophobe 202. Les plages de connexion électrique 125, 126, 127 et 128 sont quant à elles prévues pour être hydrophiles.

Ainsi, dans l'exemple de la figure 2, la face de connexion de la micropuce comprend une pluralité de zones hydrophiles, correspondant aux plages de connexion électrique 125, 126, 127 et 128, chacune entourée latéralement et séparée des autres zones hydrophiles par une zone hydrophobe (la couche 202).

Dans l'exemple de la figure 2, la face inférieure ou face de connexion de la micropuce 200 est sensiblement plane, c'est-à-dire que les plages de connexion électrique 125, 126, 127 et 128 de la micropuce affleurent au niveau de la face inférieure de la couche hydrophobe 202. A titre d'exemple, les plages de connexion électrique 125, 126, 127 et 128 sont formées selon un procédé de type damascène, comprenant une étape de dépôt de la couche hydrophobe sur toute la surface inférieure de la micropuce, suivie d'une étape de gravure de cavités destinées à recevoir les plages de connexion électrique 125, 126, 127 et 128 du côté de la face inférieure de la micropuce, suivie d'une étape de remplissage des cavités par un matériau conducteur pour former les plages de connexion électrique, suivie d'une étape de polissage mécanochimique pour planariser la surface inférieure de la puce de façon à mettre à un même niveau les faces inférieures des plages de connexion électrique 125, 126, 127 et 128 et la face inférieure de la couche hydrophobe 202.

Par les termes hydrophobe et hydrophile, on entend ici que le matériau de la couche 202 présente une mouillabilité relativement faible et que le matériau des plages de connexion électrique présente une mouillabilité relativement forte.

De façon générale, la mouillabilité d'un matériau peut être caractérisée par l'angle de contact d'une goutte de liquide sur une surface horizontale du matériau à la pression atmosphérique, c'est-à-dire l'angle entre la tangente à la goutte et la surface du matériau au point de contact triple solide/liquide/gaz. Plus l'angle de contact est faible, plus la mouillabilité du matériau est élevée.

On cherche ici à obtenir une différence de mouillabilité élevée entre la zone hydrophobe et les zones hydrophiles de la face de connexion de la micropuce, de façon à permettre le confinement d'une goutte d'un liquide sur chaque plage de connexion électrique de la micropuce, en vue de faciliter l'alignement des plages de connexion électrique de la micropuce sur les plages de connexion électrique correspondantes du substrat de report comme cela sera décrit plus en détail ci-après.

A titre d'exemple, on entend par hydrophile que l'angle de contact d'une goutte d'eau sur le matériau des plages de connexion électrique 125, 126, 127 et 128 est inférieur à 10°, et de préférence inférieur à 5°, et on entend par hydrophobe que l'angle de contact d'une goutte d'eau sur le matériau de la couche 202 est supérieur à 20°, de préférence supérieur à 60°, de préférence supérieur à 90°. Dans l'exemple de la figure 2, la différence d'angle de goutte entre le matériau hydrophile et le matériau hydrophobe est de préférence supérieure à 90°, par exemple supérieure à 110°.

La couche hydrophobe 202 est par exemple en un polymère hydrophobe, par exemple le polymère Bosch C4F8, le polytétrafluoroéthylène (TEFLON), un polymère anti adhésif du type commercialisé par la société Daikin sous la référence commerciale OPTOOL DSX, ou en tout autre matériau hydrophobe adapté.

De façon similaire, le substrat de report 250 de la figure 2 diffère du substrat de report 150 de la figure 1 principalement en ce qu'il comprend, du côté de sa face de connexion, une couche hydrophobe 252 en un matériau électriquement isolant, entourant latéralement les plages de connexion électrique 155, 156, 157 et 158 du substrat. Dans l'exemple représenté, la couche hydrophobe 252 s'étend sur sensiblement toute la surface supérieure du substrat de report non occupée par les plages de connexion électrique 155, 156, 157 et 158. A titre d'exemple, en vue de face, chacune des plages de connexion électrique 155, 156, 157 et 158 du substrat de report est entièrement entourée par la couche hydrophobe 252 et séparée des autres plages de connexion électrique par la couche hydrophobe 252. Les plages de connexion électrique 155, 156, 157 et 158 sont quant à elles prévues pour être hydrophiles.

Dans l'exemple de la figure 2, la face supérieure ou face de connexion du substrat de report 250 est sensiblement plane, c'est-à-dire que les plages de connexion électrique 155, 156, 157 et 158 du substrat de report affleurent au niveau de la face supérieure de la couche hydrophobe 252. A titre d'exemple, les plages de connexion électrique 155, 156, 157 et 158 sont formées selon un procédé de type damascène après le dépôt de la couche hydrophobe sur toute la surface supérieure du substrat de report.

Comme pour la micropuce, on cherche ici à obtenir une différence de mouillabilité élevée entre la zone hydrophobe et les zones hydrophiles de la face de connexion du substrat de report, de façon à permettre le confinement d'une goutte d'un liquide sur chaque plage de connexion électrique du substrat de report, en vue de faciliter l'alignement des plages de connexion électrique de la micropuce sur les plages de connexion électrique correspondantes du substrat de report.

A titre d'exemple, l'angle de contact d'une goutte d'eau sur le matériau des plages de connexion électrique 155, 156, 157 et 158 est inférieur à 10°, et de préférence inférieur à 5°, et l'angle de contact d'une goutte d'eau sur le matériau de la couche 252 est supérieur à 20°, de préférence supérieur à 60°, de préférence supérieur à 90°. La différence d'angle de goutte entre le matériau des plages de connexion électrique 155, 156, 157 et 158 et le matériau de la couche 252 est de préférence supérieure à 90°, par exemple supérieure à 110°.

A titre d'exemple, les plages de connexion électrique 155, 156, 157 et 158 du substrat de report 250 sont en le même matériau que les plages de connexion électrique 125, 126, 127 et 128 de la micropuce 200, et la couche hydrophobe 252 du substrat de report 250 est en le même matériau que la couche hydrophobe 202 de la micropuce 200.

Dans l'exemple de la figure 2, on prévoit, avant le report proprement dit de la micropuce 200 sur le substrat de report 250, de disposer une goutte d'un liquide 260, par exemple de l'eau, sur chaque plage de connexion électrique du substrat de report et/ou sur chaque plage de connexion électrique de la micropuce.

Dans l'exemple représenté, les gouttes sont disposées uniquement sur les plages de connexion électrique du substrat de report. Pour cela, la face supérieure du substrat de report est par exemple plongée dans un bain du liquide 260. Alternativement, le liquide 260 peut être pulvérisé sur la face supérieure du substrat de report. Du fait du contraste hydrophile/hydrophobe entre les plages de connexion électrique 155, 156, 157, 158 du substrat et la couche hydrophobe 252, des gouttes du liquide 260 sont confinées uniquement sur les plages de connexion électrique 155, 156, 157, 158, du substrat de report, soit quatre gouttes par micropuce dans l'exemple de la figure 2.

La micropuce 200 est alors rapportée sur le substrat 250, face de connexion tournée vers la face de connexion du substrat 250. Plus particulièrement, les plages de connexion électrique 125, 126, 127 et 128 de la micropuce sont posées sur les gouttes du liquide 260 surmontant les plages de connexion électrique correspondantes 155, 156, 157 et 158 du substrat de report.

Lors de cette étape, la force de rappel de capillarité exercée par les gouttes du liquide 260 sur les surfaces hydrophiles, c'est-à-dire sur les plages de connexion électrique, permet d'aligner précisément les plages de connexion électrique de la micropuce sur les plages de connexion électrique correspondantes du substrat de report.

On notera que la force de rappel de capillarité exercée par chaque microgoutte est proportionnelle à la longueur de la périphérie de la goutte, ou longueur de la ligne de triple contact air/solide/liquide de la microgoutte. Ainsi, le fait de prévoir une goutte par plage de connexion électrique de la micropuce permet de bénéficier d'une force de rappel d'alignement plus élevée que si une goutte unique était prévue pour l'alignement de la micropuce.

Une fois l'alignement de la micropuce 200 sur le substrat de report réalisé avec l'assistance de gouttes du liquide 260, la micropuce 200 est fixée sur le substrat de report 250 par collage direct des plages de connexion électrique 125, 126, 127 et 128 de la micropuce sur les plages de connexion électrique 155, 156, 157 et 158 correspondantes du substrat de report. Pour cela, une pression peut par exemple être appliquée sur la micropuce 200 pour évacuer les gouttes du liquide 260, ou le liquide 260 peut être évaporé, de façon à mettre en contact la face de connexion de la micropuce avec la face de connexion du substrat de report, et ainsi obtenir le collage direct des plages de connexion électrique 125, 126, 127 et 128 de la micropuce sur les plages de connexion électrique 155, 156, 157 et 158 du substrat de report. Les plages de connexion électrique de la micropuce et du substrat de report peuvent avoir été préparées au préalable pour obtenir une planéité suffisante pour réaliser le collage direct. Un recuit peut éventuellement être prévu après le collage, par exemple à une température comprise entre 150 et 250°C, pour augmenter l'énergie de collage.

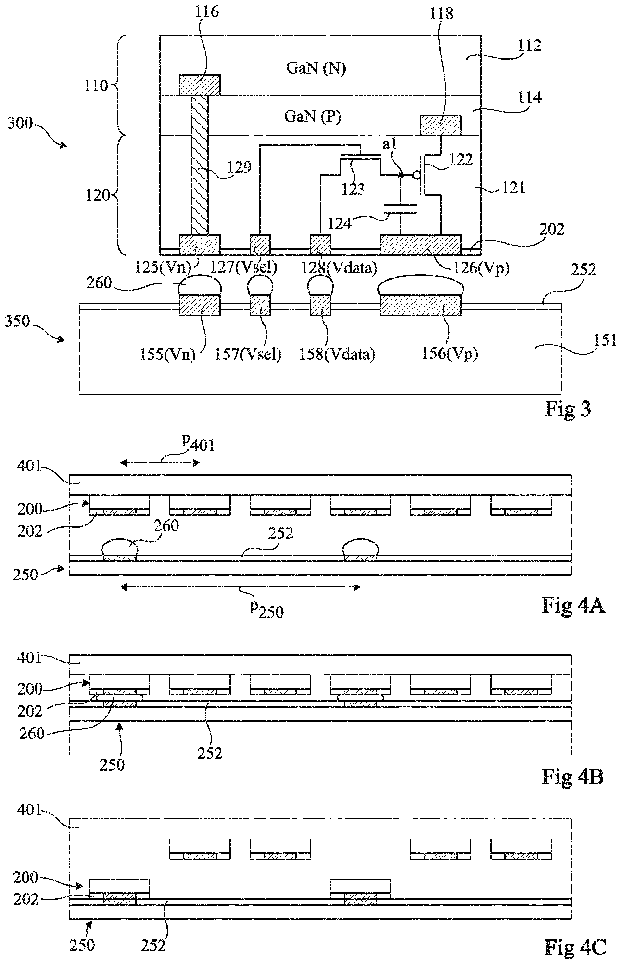

La figure 3 est une vue en coupe illustrant de façon schématique et partielle une étape de report d'une micropuce 300 sur un substrat de report 350, selon un exemple d'un mode de réalisation d'un procédé de fabrication d'un dispositif d'affichage émissif à LED.

La figure 3 représente plus particulièrement la micropuce 300 et le substrat de report 350 avant l'étape proprement dite de fixation de la micropuce sur le substrat de report.

La micropuce 300 de la figure 3 comprend des éléments communs avec la micropuce 200 de la figure 2, et le substrat de report 350 de la figure 3 comprend des éléments communs avec le substrat de report 250 de la figure 2.

Dans la suite, seules les différences entre le mode de réalisation de la figure 3 et le mode de réalisation de la figure 2 seront détaillées.

La micropuce 300 de la figure 3 diffère de la micropuce 200 de la figure 2 principalement en ce que, dans la micropuce 300, les plages de connexion électrique 125, 126, 127 et 128 forment des protubérances en saillie de la face inférieure de la puce. Ainsi, à la différence de la micropuce 200 dont la face de connexion est sensiblement plane, la micropuce 300 présente une face de connexion structurée. Plus particulièrement, les protubérances formées par les plages de connexion électrique de la micropuce ont une forme en mésa ou en plateau, la face supérieure de chaque protubérance formant une arête vive avec les flancs de la protubérance.

De façon similaire, le substrat de report 350 de la figure 3 diffère du substrat de report 250 de la figure 2 principalement en ce que, dans le substrat de report 350, les plages de connexion électrique 155, 156, 157 et 158 forment des protubérances en saillie de la face supérieure du substrat. Ainsi, à la différence du substrat de report 250 dont la face de connexion est sensiblement plane, le substrat report 350 présente une face de connexion structurée. Plus particulièrement, les protubérances formées par les plages de connexion électrique du substrat de report ont une forme en mésa ou en plateau, la face supérieure de chaque protubérance formant une arête vive avec les flancs de la protubérance.

Un avantage de la variante de la figure 3 est qu'elle permet de bénéficier, en plus de la différence de mouillabilité entre les plages de connexion électrique et la zone hydrophobe entourant les plages de connexion électrique, d'un effet d'ancrage des gouttes du liquide 260 sur le sommet de chaque protubérance pour maintenir les gouttes confinées sur les plages de connexion électrique.

A titre de variante, seules les plages de connexion électrique du substrat de report forment des protubérances, la face de connexion de la micropuce étant sensiblement plane tel que décrit dans l'exemple de la figure 2. Dans une autre variante, seules les plages de connexion électrique de la micropuce forment des protubérances, la face de connexion du substrat de report étant sensiblement plane tel que décrit dans l'exemple de la figure 2.

Les figures 4A, 4B et 4C sont des vues en coupe illustrant des étapes d'un exemple d'un mode de réalisation d'un procédé de fabrication d'un dispositif d'affichage émissif à LED.

La figure 4A illustre une étape au cours de laquelle, après avoir formé séparément les micropuces 200 sur un substrat de support 401, et le substrat de report 250, et après avoir disposé des gouttes du liquide 260 sur les plages de connexion électrique du substrat de report 250, on vient positionner les micropuces 200 approximativement en vis-à-vis des zones de report correspondantes du substrat 250, faces de connexion des micropuces tournées vers la face de connexion du substrat 250, en se servant du substrat de support 401 comme poignée.

A titre d'exemple, le procédé de fabrication des micropuces 200 est un procédé du type décrit dans la demande de brevet français FR 3 044 467 A1 susmentionnée, comprenant :
la formation d'une matrice de circuits de commande élémentaires 120 identiques ou similaires, dans et sur un substrat de silicium ;
la formation séparée, sur un substrat de croissance adapté, par exemple en saphir, d'une matrice correspondante de LED élémentaires 110 identiques ou similaires ;
le report, l'une sur l'autre, de la matrice de circuits de commande 120 et de la matrice de LED 110, les deux matrices étant solidarisées l'une à l'autre, par exemple par collage direct hétérogène ;
le retrait du substrat de croissance des LED et son remplacement par un substrat de support, correspondant au substrat 401 de la figure 4A, fixé par un collage dit temporaire, présentant une énergie d'adhérence plus faible que la liaison initiale entre les micropuces et le substrat de croissance des LED, de façon à faciliter une étape ultérieure de prélèvement des micropuces ; et
l'individualisation de chaque micropuce 200 en gravant autour d'elle une tranchée s'étendant verticalement de la face de connexion de la micropuce jusqu'au substrat 401, de façon à obtenir une matrice de micropuces individualisées attachées au substrat de support 401 par leurs LED, tel que représenté en figure 4A.

A titre de variante, l'étape de remplacement du substrat de croissance des LED par un substrat de support différent peut être omise, auquel cas le substrat 401 de la figure 4A est le substrat de croissance des LED. Dans ce cas, la liaison entre le substrat 401 et les LED 110 peut éventuellement être affaiblie, au moyen d'un faisceau laser projeté au travers du substrat 401 depuis sa face arrière, c'est-à-dire sa face opposée aux micropuces 200.

Dans une autre variante, l'empilement des couches semiconductrices constitutives des LED peut être rapporté sur la matrice de circuits de commande élémentaires 120 avant individualisation des LED élémentaires 110. Le substrat de croissance des LED est alors retiré pour permettre l'individualisation des LED 110, puis le substrat de support 401 peut être collé à la face des LED 110 opposée aux circuits de commande 120.

Par souci de simplification, on a représenté sur les figures 4A à 4C, ainsi que sur les figures suivantes, une seule plage de connexion électrique par micropuce. En pratique, comme indiqué précédemment, chaque micropuce comprend plusieurs plages de connexion électrique sur sa face de connexion. De plus, toujours par souci de simplification des figures, les micropuces 200 n'ont pas été détaillées sur les figures 4A à 4C et suivantes. Seule la couche hydrophobe 202 et la plage de connexion électrique unique (en surface hachurée, non référencée) sont visibles. De façon similaire, le substrat de report 250 n'a pas été détaillé sur les figures 4A à 4C et suivantes. Seule la couche hydrophobe 252 et, pour chaque micropuce, une plage de connexion électrique unique (en surface hachurée, non référencée) sont visibles.

Les micropuces 200 attachées au substrat de support 401 par leurs LED sont amenées en vis-à-vis de zones de réception correspondantes du substrat de report 250, faces de connexion tournées vers la face de connexion du substrat 250, et posées sur les gouttes du liquide 260 surmontant les plages de connexion électrique du substrat de report.

Lors de cette étape, la force de rappel de capillarité exercée par les gouttes du liquide 260 sur les plages de connexion électrique hydrophiles permet d'aligner précisément les plages de connexion électrique de chaque micropuce sur les plages de connexion électrique correspondantes du substrat de report.

On notera que le fait de rapporter simultanément plusieurs micropuces 200 sur le substrat 250 permet de bénéficier d'une force de rappel de capillarité plus élevée que si une puce unique était rapportée, dans la mesure où les forces de rappel de capillarité exercées par les gouttes associées aux différentes micropuces reportées s'additionnent.

Les micropuces 200 sont ensuite fixées sur le substrat de report 250 par collage direct des plages de connexion électrique des micropuces sur les plages de connexion électrique correspondantes du substrat de report. Pour cela, une pression peut par exemple être appliquée sur les micropuces 200 pour évacuer les gouttes du liquide 260, ou le liquide 260 peut être évaporé, de façon à obtenir un collage direct entre les micropuces et le substrat de report.

Les micropuces 200 sont ensuite détachées du substrat de support 401, et ce dernier est retiré.

En pratique, le pas p₄₀₁ des micropuces sur le substrat 401, par exemple de l'ordre de 10 à 50 µm, peut être inférieur au pas P₂₅₀ du dispositif final après report sur le substrat 250, par exemple compris entre 15 µm et 1 mm, par exemple de l'ordre de 100 à 500 µm.

Dans l'exemple décrit en relation avec les figures 4A à 4C, ainsi que dans les exemples des figures suivantes, le pas p₂₅₀ des micropuces 200 sur le substrat de report 250 est un multiple du pas p₄₀₁ des micropuces sur le substrat de support 401. Ainsi, on prévoit de reporter seulement une partie des micropuces 200 du substrat 401 sur le substrat 250, au pas du substrat de report 250 (soit une puce sur n avec n = p₂₅₀/p₄₀₁), puis, si besoin, de décaler le substrat 401 avec les micropuces restantes pour reporter une autre partie des micropuces 200 du substrat 401 sur le substrat 250, et ainsi de suite jusqu'à ce que toutes les micropuces du dispositif d'affichage aient été fixées sur le substrat de report 250.

A chaque itération, une fois l'alignement des micropuces 200 sur le substrat de report réalisé avec l'assistance de gouttes du liquide 260 (figure 4B), les micropuces 200 sont détachées sélectivement du substrat de support 401. Le substrat de support 401 et les micropuces 200 restantes sont ensuite retirés comme illustré par la figure 4C.

Pour détacher sélectivement les micropuces 200 du substrat de support 401, on peut prévoir un collage faible entre le substrat de support 401 et les micropuces 200, de façon que seules les micropuces 200 alignées avec des plages de connexion correspondantes du substrat de report 250 soient arrachées lors du retrait du substrat de support 401, sous l'effet de la force de capillarité exercée par les gouttes du liquide 260 ou sous l'effet de la force de collage direct entre la micropuce et le substrat de report. A titre d'exemple, les micropuces 200 sont collées au substrat de support 401 à l'aide d'un polymère de type C4F8, TEFLON, ou OPTOOL DSX, ou par tout autre adhésif permettant d'obtenir une énergie de collage entre les micropuces 200 et le substrat de support 401 inférieure à l'énergie d'adhérence entre les micropuces 200 et le substrat de report 250.

A titre de variante, dans le cas où le substrat de support 401 est transparent, le collage des micropuces 200 au substrat de support 401 peut être réalisé par une résine adaptée à être dégradée par un rayonnement ultraviolet, par exemple une résine de type BREWER 305. Une insolation laser localisée de la résine peut alors être réalisée au travers du substrat 401, pour détacher sélectivement une partie des micropuces 200.

Dans le cas où le substrat de support 401 est le substrat de croissance des LED 110, ce dernier peut présenter une adhérence relativement forte avec les micropuces 200. Dans ce cas, on peut utiliser un procédé de décollement sélectif au moyen d'un faisceau laser localisé projeté à travers le substrat 401, par exemple un procédé du type décrit dans le brevet US 6 071 795 A. Par exemple, dans le cas d'un substrat de croissance 401 en saphir et de LED au nitrure de gallium un laser à 458 nm peut être utilisé, avec une puissance optique comprise entre 10 mW/mm² et 10 W/mm², et un temps d'exposition compris entre 1 seconde et 1 minute pour chaque puce à décoller. Après l'exposition au laser, du gallium liquide est présent à l'interface entre la LED et le saphir. La micropuce tient alors par capillarité sur le substrat 401, jusqu'à son report sur le substrat 250.

On notera que pour augmenter la force de collage entre les micropuces 200 et le substrat de report 250, et ainsi faciliter le décollement du substrat de support 401, on peut effectuer, avant le retrait du substrat 401 (figure 4C), un recuit visant à augmenter l'énergie de collage entre les micropuces et le substrat de report, par exemple à une température comprise entre 150 et 250°C.

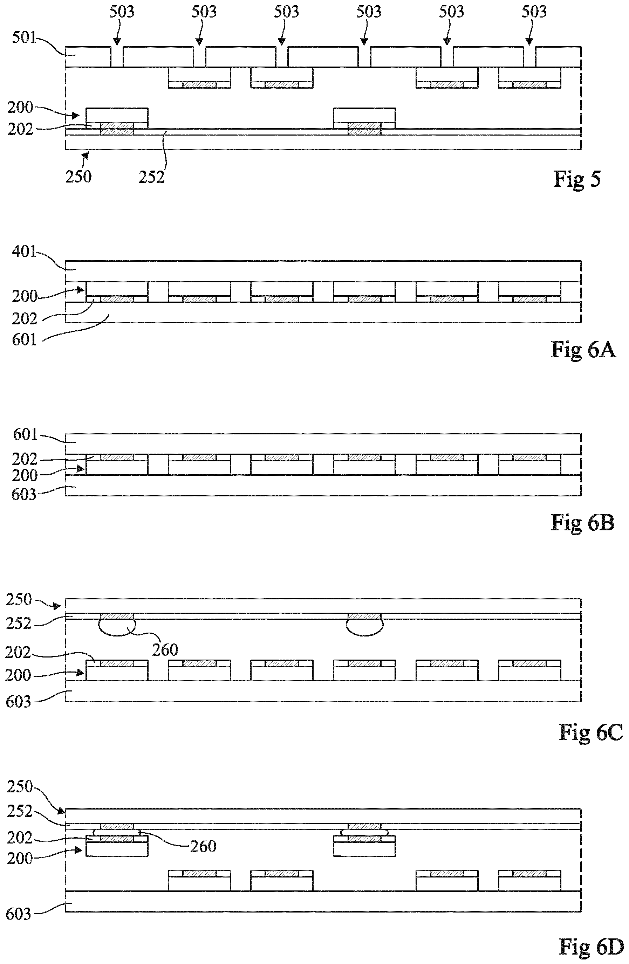

La figure 5 est une vue en coupe illustrant une variante de réalisation du procédé des figures 4A à 4C.

Le procédé de la figure 5 diffère du procédé des figures 4A à 4C principalement en ce que, dans le procédé de la figure 5, le substrat de support 401 des figures 4A à 4C est remplacé par un substrat de support 501, comprenant au moins une ouverture traversante 503 en regard de chaque micropuce 200. La prévision des ouvertures traversantes 503 permet de faciliter le détachement sélectif des micropuces 200 lors de leur report sur le substrat 250. A titre d'exemple, les micropuces 200 sont maintenues collées au substrat 501 par un adhésif, et un flux d'air comprimé est injecté de façon localisée dans les ouvertures 503 situées en regard des micropuces à détacher, pour obtenir leur décollement. A titre de variante, des microaiguilles peuvent être utilisées pour pousser de façon sélective les micropuces à détacher à travers les ouvertures 503 correspondantes. A titre de variante, les micropuces sont maintenues collées au substrat 501 par aspiration à travers les ouvertures 503, puis l'aspiration est interrompue de façon localisée en regard des micropuces à détacher, pour obtenir leur décollement.

Les figures 6A à 6D sont des vues en coupe illustrant des étapes d'un autre exemple d'un mode de réalisation d'un procédé de fabrication d'un dispositif d'affichage émissif à LED.

La figure 6A illustre une étape au cours de laquelle, après avoir formé les micropuces 200 sur un premier substrat de support 401 de façon identique ou similaire à ce qui a été décrit précédemment en relation avec la figure 4A, les micropuces 200 sont transférées du substrat 401 sur un deuxième substrat de support 601, sans changement de pas. Pour cela, les micropuces 200 sont disposées sur le substrat 601 en se servant du substrat 401 comme poignée. Les micropuces 200 sont mises en contact, par leurs faces de connexion, c'est-à-dire leurs faces opposées aux LED 110, avec une face du substrat 601. Un collage temporaire à l'aide d'une couche adhésive peut être prévu entre la face de connexion des micropuces et le substrat 601. A titre de variante, les micropuces 601 sont simplement posées sur la face supérieure du substrat 601. Le substrat de support initial 401 est ensuite retiré.

La figure 6B illustre une étape postérieure au retrait du substrat de support initial 401, au cours de laquelle les micropuces 200 sont transférées du deuxième substrat de support 601 sur la face supérieure d'un troisième substrat de support 603, toujours en conservant le pas initial. Dans le cas où les micropuces 200 sont collées au substrat de support temporaire 601 par une couche adhésive, les micropuces peuvent être reportées sur la face supérieure du substrat 603 en se servant du substrat 601 comme poignée. Dans le cas où les micropuces 200 sont simplement posées sur la face supérieure du substrat de support temporaire 601, le substrat 603 peut être posé sur la face supérieure des micropuces 200, c'est-à-dire côté LED 110, puis l'ensemble comprenant le substrat 601, les micropuces 200 et le substrat 603 est retourné de façon que les micropuces 200 se retrouvent côté face supérieure du substrat 603. Le substrat de support temporaire 601 est ensuite retiré.

La figure 6C illustre une étape postérieure au retrait du substrat 601. A ce stade, les micropuces 200 sont simplement posées (et non collées) sur la face supérieure du substrat de support 603, les faces de connexion des micropuces étant tournées vers le haut, c'est-à-dire à l'opposé du substrat 603.

Le substrat de report 250 sur lequel on souhaite fixer des micropuces 200, est alors positionné au-dessus du substrat 603 et des micropuces 200, face de connexion tournée vers les faces de connexion des micropuces. Au préalable, des gouttes du liquide 260 ont été disposées sur les plages de connexion électrique du substrat de report 250. Les micropuces 200, posées sur le substrat de support 603, sont amenées en vis-à-vis des zones de réception correspondantes du substrat de report 250, puis les plages de connexion électrique des micropuces 200 sont mises en contact avec les gouttes du liquide 260 disposées sur les plages de connexion électrique correspondantes du substrat de report.

La force de rappel de capillarité exercée par les gouttes du liquide 260 sur les plages de connexion électrique hydrophiles attire les micropuces 200 (qui sont libres de bouger par rapport au substrat 603 du fait de l'absence de collage entre les micropuces et le substrat), et conduit à auto-aligner précisément les plages de connexion de chaque micropuce sur les plages de connexion électrique correspondantes du substrat de report.

Les micropuces 200 sont ensuite fixées sur le substrat de report 250 par collage direct. Pour cela, une pression peut par exemple être appliquée sur les micropuces 200 pour évacuer les gouttes du liquide 260, ou le liquide 260 peut être évaporé, de façon à obtenir un collage direct entre les micropuces et le substrat de report.

Le substrat de support 603 et les micropuces 200 restantes peuvent être retirés comme illustré par la figure 6D.

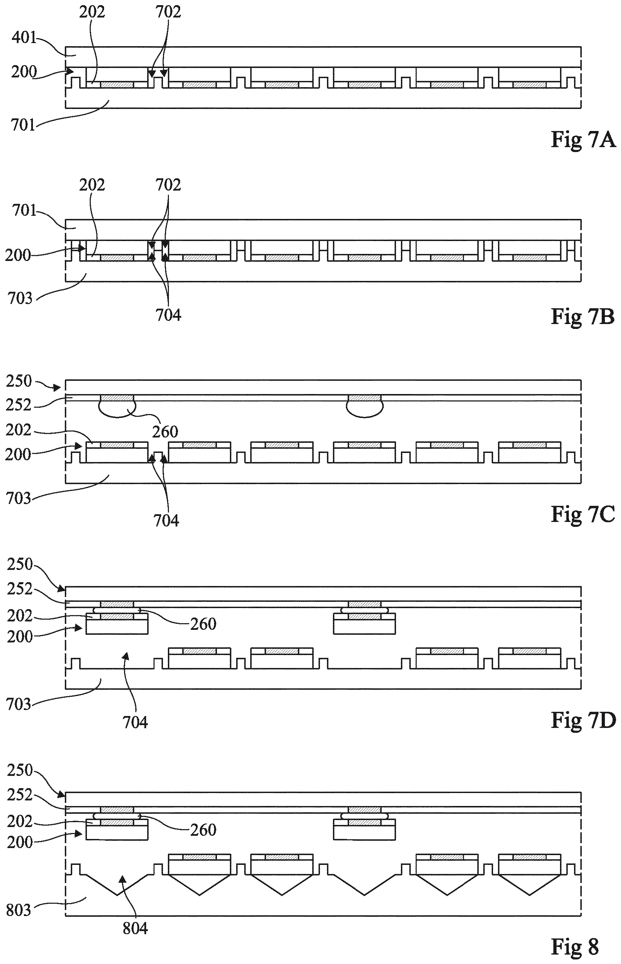

Les figures 7A à 7D sont des vues en coupe illustrant des étapes d'un autre exemple d'un mode de réalisation d'un procédé de fabrication d'un dispositif d'affichage émissif à LED.

Le procédé des figures 7A à 7D est similaire au procédé des figures 6A à 6D, et diffère du procédé des figures 6A à 6D principalement en ce que, dans le procédé des figures 7A à 7D, les substrats de support 601 et 603 du procédé des figures 6A à 6D sont remplacés par des substrats 701 et 703 respectivement. Les substrats 701 et 703 diffèrent des substrats 601 et 603 en ce qu'ils comportent chacun, du côté de leur face destinée à recevoir les micropuces 200, des cavités 702 (pour le substrat 701), respectivement 704 (pour le substrat 703), destinées à recevoir les micropuces 200.

Plus particulièrement, lors du transfert des micropuces 200 du substrat de support initial 401 sur le substrat 701 (figure 7A), chaque micropuce 200 est disposée dans une cavité 702 du substrat 701, et est séparée des autres micropuces 200 reportées sur le substrat 701 par les parois latérales de la cavité 702. Autrement dit, le pas des cavités 702 du substrat 701 est sensiblement identique au pas des micropuces 200 sur le substrat 401. De façon similaire à ce qui a été décrit en relation avec les figures 6A à 6D, les micropuces 200 peuvent être fixées au substrat de support temporaire 701 par une couche adhésive, ou peuvent être simplement posées sur le substrat 701. Le substrat de support initial 401 est ensuite retiré.

Par ailleurs, lors du transfert des micropuces 200 du substrat de support temporaire 701 sur le substrat de support 703 (figure 7B), chaque micropuce 200 est disposée dans une cavité 704 du substrat 703, et est séparée des autres micropuces 200 par les parois latérales de la cavité 704. Autrement dit, le pas des cavités 704 du substrat 703 est sensiblement identique au pas des micropuces 200 sur le substrat initial 401. De façon similaire à ce qui a été décrit en relation avec les figures 6A à 6D, les micropuces 200 sont simplement posées sur le substrat de support 703.

Les autres étapes du procédé sont identiques ou similaires à ce qui a été décrit précédemment en relation avec les figures 6A à 6D.

Un avantage de la variante des figures 7A à 7D est de faciliter la manipulation des substrats de support 701 et/ou 703 une fois ces derniers chargés en micropuces 200, grâce au maintien latéral des micropuces obtenu par la prévision des cavités 702, 704.

La figure 8 est une vue en coupe illustrant une variante de réalisation du procédé des figures 7A à 7D.

La figure 8 illustre plus particulièrement une étape finale du procédé, correspondant à l'étape de la figure 7D.

Dans la variante de la figure 8, le substrat de support 703 du procédé des figures 7A à 7D est remplacé par un substrat de support 803. Le substrat 803 comprend des cavités 804 de maintien des micropuces 200, disposées selon un pas sensiblement égal au pas des micropuces sur le substrat de support initial 401. Le substrat 803 du procédé de la figure 8 diffère du substrat 703 du procédé des figures 7A à 7D principalement en ce que le fond de chaque cavité 804 du substrat 803 est non plan. Autrement dit, à la différence du substrat 703 dans lequel toute la surface d'une micropuce 200 opposée à la face de connexion de la micropuce est en contact avec le fond d'une cavité 704 du substrat, dans l'exemple de la figure 8, pour chaque micropuce 200, seule une partie de la surface de la micropuce opposée à sa face de connexion est en contact avec le fond de la cavité 804 dans laquelle est disposée la micropuce. Ceci permet d'empêcher une adhérence non souhaitée des micropuces 200 au fond des cavités du substrat 803, et ainsi de faciliter le prélèvement des micropuces par le substrat de report 250 lors de l'étape d'auto-assemblage.

A titre d'exemple, le fond de chaque cavité 804 du substrat 803 peut avoir une forme en creux, par exemple la forme d'une portion de rainure à section triangulaire. Plus généralement, toute autre forme non plane adaptée à obtenir l'effet anti-adhérent recherché peut être utilisée, par exemple une forme bombée.

Des modes de réalisation particuliers ont été décrits. Diverses variantes et modifications apparaîtront à l'homme de l'art. En particulier, les modes de réalisation décrits ne se limitent pas aux exemples particuliers de dimensions et de matériaux mentionnés dans la description.

De plus, on comprendra que les procédés des figures 4A à 4C, 5, 6A à 6D, 7A à 7D et 8 peuvent être mis en oeuvre avec des micropuces 300 et/ou avec un substrat de report 350 du type décrit en relation avec la figure 3.

Par ailleurs, bien que l'on ait décrit uniquement des exemples de réalisation dans lesquels les micropuces reportées sur le substrat de report comportent chacune une LED et un circuit de commande de la LED, les modes de réalisation décrits ne se limitent pas à ce cas particulier. A titre de variante, chaque micropuce peut comporter une pluralité de LED et un circuit actif de commande de la pluralité de LED. De plus, dans une autre variante, chaque micropuce peut comporter uniquement une ou plusieurs LED, sans circuit de commande, la ou les LED de la micropuce étant alors commandées par des circuits externes à la micropuce, disposés par exemple à la périphérie du substrat de report.

En outre, les modes de réalisation décrits ne se limitent pas aux exemples représentés dans lesquels chaque micropuce comprend quatre plages de connexion électrique.

## Revendications

1. Procédé de fabrication d'un dispositif d'affichage émissif à LED, comprenant les étapes suivantes :
a) réaliser une pluralité de puces (200 ; 300) comprenant chacune au moins une LED (110), et, sur une face de connexion de la puce, une pluralité de plages de connexion électrique hydrophiles (125, 126, 127, 128) et une zone hydrophobe (202), chaque plage de connexion électrique de la puce étant entourée et séparée des autres plages de connexion électrique de la puce par la zone hydrophobe ;
b) réaliser un substrat de report (250 ; 350) comprenant, pour chaque puce (200 ; 300), sur une face de connexion du substrat de report, une pluralité de plages de connexion électrique hydrophiles (155, 156, 157, 158) destinées à être connectées respectivement aux plages de connexion électrique de la puce, et une zone hydrophobe (252), chaque plage de connexion électrique de substrat de report étant entourée et séparée des autres plages de connexion électrique du substrat de report par la zone hydrophobe ;
c) disposer une goutte d'un liquide (260) sur chaque plage de connexion électrique du substrat de report (250 ; 350) et/ou sur chaque plage de connexion électrique de chaque puce (200 ; 300) ; et
d) fixer les puces (200 ; 300) sur le substrat de report (250 ; 350) par collage direct de façon à connecter électriquement les plages de connexion électrique de chaque puce aux plages de connexion électrique correspondantes du substrat de report, en utilisant la force de rappel de capillarité des gouttes pour aligner les plages de connexion électrique des puces (200 ; 300) sur les plages de connexion électrique correspondantes du substrat de report (250 ; 350).

2. Procédé selon la revendication 1, dans lequel les plages de connexion électrique (125, 126, 127, 128, 155, 156, 157, 158) des puces (200 ; 300) et du substrat de report (250 ; 350) sont en métal, et dans lequel les zones hydrophobes (202, 252) des puces (200 ; 300) et du substrat de report (250 ; 350) sont en un polymère hydrophobe.

3. Procédé selon la revendication 1 ou 2, dans lequel les plages de connexion électrique (125, 126, 127, 128, 155, 156, 157, 158) des puces (200 ; 300) et du substrat de report (250 ; 350) sont en un matériau formant un angle de goutte inférieur à 10° avec le liquide (260), et dans lequel les zones hydrophobes (202 ; 252) des puces (200 ; 300) et du substrat de report (250 ; 350) sont en un matériau formant un angle de goutte supérieur à 20° avec le liquide (260).

4. Procédé selon l'une quelconque des revendications 1 à 3, dans lequel :
dans chaque puce (200), la face de connexion de la puce est plane, c'est-à-dire que les plages de connexion électrique (125, 126, 127, 128) de la puce affleurent au niveau de la face externe de la zone hydrophobe (202) ; et/ou
la face de connexion du substrat de report (250) est plane, c'est-à-dire que les plages de connexion électrique (155, 156, 157, 158) du substrat de report affleurent au niveau de la face externe de la zone hydrophobe (252).

5. Procédé selon l'une quelconque des revendications 1 à 3, dans lequel :
dans chaque puce (300), les plages de connexion électrique (125, 126, 127, 128) de la puce forment des protubérances en saillie de la face de connexion de la puce ; et/ou
les plages de connexion électrique (155, 156, 157, 158) du substrat de report (350) forment des protubérances en saillie de la face de connexion du substrat de report.

6. Procédé selon l'une quelconque des revendications 1 à 5, dans lequel :
à l'issue de l'étape a), les puces (200 ; 300) sont disposées sur un substrat de support (401 ; 501 ; 603 ; 703 ; 803) avec un pas inter-puces inférieur au pas inter-puces du dispositif d'affichage final ; et
à l'étape d), plusieurs puces (200 ; 300) sont sélectivement détachées du substrat de support (401 ; 501 ; 603 ; 703 ; 803) au pas du dispositif d'affichage final et fixées au substrat de report à ce même pas.

7. Procédé selon la revendication 6, dans lequel le détachement sélectif des puces (200 ; 300) est réalisé au moyen d'un faisceau laser localisé projeté depuis la face du substrat de support (401) opposée aux puces.

8. Procédé selon la revendication 6, dans lequel le substrat de support (501) présente une ou plusieurs ouvertures traversantes (503) en regard de chaque puce (200 ; 300), le détachement sélectif des puces (200 ; 300) étant réalisé par l'intermédiaire de ces ouvertures.

9. Procédé selon la revendication 6, dans lequel :
à l'issue de l'étape a), les puces (200 ; 300) sont seulement posées, sans collage, sur le substrat de support (603 ; 703 ; 803) ; et
à l'étape d) le substrat de report est amené au-dessus des puces (200 ; 300), face de connexion tournée vers les faces de connexion des puces, et posé sur les puces de façon à prélever simultanément plusieurs puces au pas du dispositif d'affichage final.

10. Procédé selon la revendication 9, dans lequel le substrat de support (703 ; 803) comprend des cavités (704 ; 804) dans lesquelles sont disposées les puces (200 ; 300) de façon que les puces soient maintenues latéralement par les parois des cavités.

11. Procédé selon la revendication 10, dans lequel le fond de chaque cavité (804) du substrat de support (803) est non plan.

12. Procédé selon l'une quelconque des revendications 1 à 11, dans lequel chaque puce (200 ; 300) comprend un empilement d'une LED (110) et d'un circuit actif (120) de commande de la LED.

13. Dispositif d'affichage émissif à LED réalisé par un procédé selon l'une quelconque des revendications 1 à 12, ce dispositif comprenant :
une pluralité de puces (200 ; 300) comprenant chacune au moins une LED (110), et, sur une face de connexion de la puce, une pluralité de plages de connexion électrique hydrophiles (125, 126, 127, 128) et une zone hydrophobe (202), chaque plage de connexion électrique de la puce étant entourée et séparée des autres plages de connexion électrique de la puce par la zone hydrophobe ; et
un substrat de report (250 ; 350) comprenant, pour chaque puce (200 ; 300), sur une face de connexion du substrat de report, une pluralité de plages de connexion électrique hydrophiles (155, 156, 157, 158) connectées respectivement aux plages de connexion électrique de la puce, et une zone hydrophobe (252), chaque plage de connexion électrique du substrat de report étant entourée et séparée des autres plages de connexion électrique du substrat de report par la zone hydrophobe,
dispositif dans lequel les puces (200 ; 300) sont fixées sur le substrat de report (250 ; 350) par collage direct de façon à aligner et connecter électriquement les plages de connexion électrique de chaque puce aux plages de connexion électrique correspondantes du substrat de report.

## Patentansprüche

1. Ein Verfahren zur Herstellung einer emittierenden LED-Anzeigevorrichtung, das die folgenden Schritte aufweist:
a) Ausbilden einer Vielzahl von Chips (200; 300), die jeweils wenigstens eine LED (110) und, auf einer Verbindungsfläche des Chips, eine Vielzahl von hydrophilen elektrischen Verbindungsbereichen (125, 126, 127, 128) und einen hydrophoben Bereich (202) aufweist, wobei jeder elektrische Verbindungsbereich des Chips von dem hydrophoben Bereich umgeben und durch diesen von den anderen elektrischen Verbindungsbereichen des Chips getrennt ist;
b) Ausbilden eines Transfersubstrats (250; 350) aufweisend für jeden Chip (200; 300) auf einer Verbindungsfläche des Transfersubstrats eine Vielzahl von hydrophilen elektrischen Verbindungsbereichen (155, 156, 157, 158), die dazu bestimmt sind, jeweils mit den elektrischen Verbindungsbereichen des Chips verbunden zu werden, und einen hydrophoben Bereich (252), wobei jeder elektrische Verbindungsbereich des Transfersubstrats von dem hydrophoben Bereich umgeben und durch den hydrophoben Bereich von den anderen elektrischen Verbindungsbereichen des Transfersubstrats getrennt ist;
c) Anordnen eines Tropfens einer Flüssigkeit (260) auf jeder elektrischen Verbindungsfläche des Transfersubstrats (250; 350) und/oder auf jeder elektrischen Verbindungsfläche jedes Chips (200; 300); und
d) Befestigen der Chips (200; 300) an dem Transfersubstrat (250; 350) durch direktes Bonden, um die elektrischen Verbindungsbereiche jedes Chips mit den jeweiligen elektrischen Verbindungsbereichen des Transfersubstrats elektrisch zu verbinden, und zwar unter Verwendung der kapillaren Rückstellkraft der Tropfen, um die elektrischen Verbindungsbereiche der Chips (200; 300) mit den entsprechenden elektrischen Verbindungsbereichen des Transfersubstrats (250; 350) auszurichten.

2. Verfahren nach Anspruch 1, wobei die elektrischen Verbindungsbereiche (125, 126, 127, 128, 155, 156, 157, 158) der Chips (200; 300) und des Transfersubstrats (250; 350) aus Metall hergestellt sind, und wobei die hydrophoben Bereiche (202, 252) der Chips (200; 300) und des Transfersubstrats (250; 350) aus einem hydrophoben Polymer hergestellt sind.

3. Verfahren nach Anspruch 1 oder 2, wobei die elektrischen Verbindungsbereiche (125, 126, 127, 128, 155, 156, 157, 158) der Chips (200; 300) und des Transfersubstrats (250; 350) aus einem Material hergestellt sind, das mit der Flüssigkeit (260) einen Tropfenkontaktwinkel kleiner als 10° bildet, und wobei die hydrophoben Bereiche (202; 252) der Chips (200; 300) und des Transfersubstrats (250; 350) aus einem Material hergestellt sind, das mit der Flüssigkeit (260) einen Tropfenkontaktwinkel größer als 20° bildet.

4. Verfahren nach einem der Ansprüche 1 bis 3, wobei:
bei jedem Chip (200) die Verbindungsfläche des Chips planar ist, d.h. die elektrischen Verbindungsbereiche (125, 126, 127, 128) des Chips sind bündig mit der externen Oberflache des hydrophoben Bereichs (202); und/oder
die Verbindungsfläche des Transfersubstrats (250) planar ist, d.h. die elektrischen Verbindungsbereiche (155, 156, 157, 158) des Transfersubstrats sind bündig mit der externen Oberflache des hydrophoben Bereichs (252).

5. Verfahren nach einem der Ansprüche 1 bis 3, wobei:
bei jedem Chip (300) die elektrischen Verbindungsbereiche (125, 126, 127, 128) des Chips erhabene Bereiche bilden, die aus der Verbindungsfläche des Chips hervorstehen; und/oder
die elektrischen Verbindungsbereiche (155, 156, 157, 158) des Transfersubstrats (350) erhabene Bereiche bilden, die aus der Verbindungsfläche des Transfersubstrats hervorstehen.

6. Verfahren nach einem der Ansprüche 1 bis 5, wobei:
am Ende von Schritt a) die Chips (200; 300) auf einem Trägersubstrat (401; 501; 603; 703; 803) mit einem Abstand zwischen den Chips angeordnet werden, der kleiner ist als der Abstand zwischen den Chips der endgültigen Anzeigevorrichtung; und
in Schritt d) eine Vielzahl von Chips (200; 300) selektiv von dem Trägersubstrat (401; 501; 603; 703; 803) getrennt werden und zwar im Abstand der endgültigen Anzeigevorrichtung, und auf dem Transfersubstrat im gleichen Abstand befestigt werden.

7. Verfahren nach Anspruch 6, wobei das selektive Trennen der Chips (200; 300) mit Hilfe eines lokalen Laserstrahls erreicht wird, der von der den Chips gegenüberliegenden Oberfläche des Trägersubstrats (401) projiziert wird.

8. Verfahren nach Anspruch 6, wobei das Trägersubstrat (501) eine oder mehrere Durchgangsöffnungen (503) gegenüber jedem Chip (200; 300) aufweist, wobei das selektive Trennen der Chips (200; 300) über diese Öffnungen erfolgt.

9. Verfahren nach Anspruch 6, wobei:
am Ende von Schritt a) die Chips (200; 300) ohne Bonden auf das Trägersubstrat (603; 703; 803) aufgelegt werden; und
in Schritt d) das Transfersubstrat derart über die Chips (200; 300) gebracht wird, dass seine Verbindungsfläche den Verbindungsflächen der Chips zugewandt ist, und das Transfersubstrat auf die Chips gelegt wird, um gleichzeitig eine Vielzahl von Chips im Abstand der endgültigen Anzeigevorrichtung aufzunehmen.

10. Verfahren nach Anspruch 9, wobei das Trägersubstrat (703; 803) Hohlräume (704; 804) aufweist, in denen die Chips (200; 300) so angeordnet sind, dass die Chips seitlich durch die Hohlraumwände gehalten werden.

11. Verfahren nach Anspruch 10, wobei der Boden jedes Hohlraums (804) des Trägersubstrats (803) nicht planar ist.

12. Verfahren nach einem der Ansprüche 1 bis 11, wobei jeder Chip (200; 300) einen Stapel aus einer LED (110) und einer aktiven Schaltung (120) zur Steuerung der LED aufweist.

13. Eine emittierende LED-Anzeigevorrichtung, realisiert durch ein Verfahren nach einem der Ansprüche 1 bis 12, wobei diese Vorrichtung Folgendes aufweist:
eine Vielzahl von Chips (200; 300), die jeweils wenigstens eine LED (110) und auf einer Verbindungsfläche des Chips eine Vielzahl von hydrophilen elektrischen Verbindungsbereichen (125, 126, 127, 128) und einen hydrophobe Bereich (202) aufweisen, wobei jeder elektrische Verbindungsbereich des Chips von dem hydrophoben Bereich umgeben und durch diesen von den anderen elektrischen Verbindungsbereichen des Chips getrennt ist; und
ein Transfersubstrat (250; 350), das für jeden Chip (200; 300) auf einer Verbindungsfläche des Transfersubstrats eine Vielzahl von hydrophilen elektrischen Verbindungsbereichen (155, 156, 157, 158), die jeweils mit den elektrischen Verbindungsbereichen des Chips verbunden sind, und einen hydrophoben Bereich (252) aufweist, wobei jeder elektrische Verbindungsbereich des Transfersubstrats von dem hydrophoben Bereich umgeben und durch diesen von den anderen elektrischen Verbindungsbereichen des Transfersubstrats getrennt ist,
wobei die Chips (200; 300) an dem Transfersubstrat (250; 350) durch direktes Bonden befestigt sind, um die elektrischen Verbindungsbereiche jedes Chips mit den jeweiligen elektrischen Verbindungsbereichen des Transfersubstrats auszurichten und elektrisch zu verbinden.

## Claims

1. A method of manufacturing an emissive LED display device, comprising the steps of:
a) forming a plurality of chips (200; 300), each comprising at least one LED (110) and, on a connection surface of the chip, a plurality of hydrophilic electric connection areas (125, 126, 127, 128) and a hydrophobic area (202), each electric connection area of the chip being surrounded and separated from the other electric connection areas of the chip by the hydrophobic area;
b) forming a transfer substrate (250; 350) comprising, for each chip (200; 300), on a connection surface of the transfer substrate, a plurality of hydrophilic electric connection areas (155, 156, 157, 158) intended to be respectively connected to the electric connection areas of the chip, and a hydrophobic area (252), each electric connection area of the transfer substrate being surrounded and separated from the other electric connection areas of the transfer substrate by the hydrophobic area;
c) arranging a drop of a liquid (260) on each electric connection area of the transfer substrate (250; 350) and/or on each electric connection area of each chip (200; 300); and
d) affixing the chips (200; 300) to the transfer substrate (250; 350) by direct bonding to electrically connect the electric connection areas of each chip to the corresponding electric connection areas of the transfer substrate, using the capillary restoring force of the drops to align the electric connection areas of the chips (200; 300) with the corresponding electric connection areas of the transfer substrate (250; 350).

2. The method of claim 1, wherein the electric connection areas (125, 126, 127, 128, 155, 156, 157, 158) of the chips (200; 300) and of the transfer substrate (250; 350) are made of metal, and wherein the hydrophobic areas (202, 252) of the chips (200; 300) and of the transfer substrate (250; 350) are made of a hydrophobic polymer.

3. The method of claim 1 or 2, wherein the electric connection areas (125, 126, 127, 128, 155, 156, 157, 158) of the chips (200 ; 300) and of the transfer substrate (250; 350) are made of a material forming a drop contact angle smaller than 10° with the liquid (260), and wherein the hydrophobic areas (202; 252) of the chips (200; 300) and of the transfer substrate (250; 350) are made of a material forming a drop contact angle greater than 20° with the liquid (260).

4. The method of any of claims 1 to 3, wherein:
in each chip (200), the connection surface of the chip is planar, that is, the electric connection areas (125, 126, 127, 128) of the chip are flush with the external surface of the hydrophobic area (202); and/or
the connection surface of the transfer substrate (250) is planar, that is, the electric connection areas (155, 156, 157, 158) of the transfer substrate are flush with the external surface of the hydrophobic area (252).

5. The method of any of claims 1 to 3, wherein:
in each chip (300), the electric connection areas (125, 126, 127, 128) of the chip form raised areas protruding from the connection surface of the chip; and/or
the electric connection areas (155, 156, 157, 158) of the transfer substrate (350) form raised areas protruding from the connection surface of the transfer substrate.

6. The method of any of claims 1 to 5, wherein:
at the end of step a), the chips (200; 300) are arranged on a support substrate (401; 501; 603; 703; 803) with a pitch between chips smaller than the pitch between chips of the final display device; and
at step d), a plurality of chips (200; 300) are selectively separated from the support substrate (401; 501; 603; 703; 803) at the pitch of the final display device and affixed to the transfer substrate at this same pitch.

7. The method of claim 6, wherein the selective separation of the chips (200; 300) is realized by means of a local laser beam projected from the surface of the support substrate (401) opposite to the chips.

8. The method of claim 6, wherein the support substrate (501) comprises one or a plurality of through openings (503) opposite each chip (200; 300), the selective separation of the chips (200; 300) being performed via these openings.

9. The method of claim 6, wherein:
at the end of step a), the chips (200; 300) are only laid, with no bonding, on the support substrate (603; 703; 803); and
at step d), the transfer substrate is brought above the chips (200; 300), with its connection surface facing the connection surfaces of the chips, and laid on the chips to simultaneously pick up a plurality of chips at the pitch of the final display device.

10. The method of claim 9, wherein the support substrate (703; 803) comprises cavities (704; 804) having the chips (200; 300) arranged therein so that the chips are laterally held by the cavity walls.

11. The method of claim 10, wherein the bottom of each cavity (804) of the support substrate (803) is non-planar.

12. The method of any of claims 1 to 11, wherein each chip (200; 300) comprises a stack of a LED (110) and of an active circuit (120) for controlling the LED.

13. An emissive LED display device realized by a method according to any of claims 1 to 12, this device comprising:
a plurality of chips (200; 300), each comprising at least one LED (110) and, on a connection surface of the chip, a plurality of hydrophilic electric connection areas (125, 126, 127, 128) and a hydrophobic area (202), each electric connection area of the chip being surrounded and separated from the other electric connection areas of the chip by the hydrophobic area; and
a transfer substrate (250; 350) comprising, for each chip (200; 300), on a connection surface of the transfer substrate, a plurality of hydrophilic electric connection areas (155, 156, 157, 158) respectively connected to the electric connection areas of the chip, and a hydrophobic area (252), each electric connection area of the transfer substrate being surrounded and separated from the other electric connection areas of the transfer substrate by the hydrophobic area,
wherein the chips (200; 300) of the device are affixed to the transfer substrate (250; 350) by direct bonding to align and electrically connect the electric connection areas of each chip to the corresponding electric connection areas of the transfer substrate.
